# EUROPÄISCHE PATENTSCHRIFT

(11) **EP 1 697 296 B1**
(45) Veröffentlichungstag und Bekanntmachung des Hinweises auf die Patenterteilung: **19.03.2014**
(21) Anmeldenummer: 04803895.4
(22) Anmeldetag: 15.12.2004
(51) Int. Cl.: C23C 18/08, C23C 18/12, C07C 53/06

(54) **KUPFER(I)FORMIATKOMPLEXE**
COPPER (I) FORMATE COMPLEXES
COMPLEXES DE FORMIATE DE CUIVRE(I)

(30) Priorität: 18.12.2003 DE 10360046
(43) Veröffentlichungstag der Anmeldung: 06.09.2006
(73) Patentinhaber: BASF SE, 67056 Ludwigshafen (DE)
(72) Erfinder: WITTENBECHER, Lars, 68159 Mannheim (DE); LANG, Heinrich, 09125 Chemnitz (DE); Shen, Yingzhong, Nanjing 210016 (CN)
(86) Internationale Anmeldenummer: PCT/EP2004/014275
(87) Internationale Veröffentlichungsnummer: WO 2005/058789

(56) Entgegenhaltungen:
- WO-A-03/053895
- G.A. BOWMAKER, EFFENDY, J. V. HANNA, P.C. HEALY, J.C. REID, C.E.F. RICKARD, A.H. WHITE: "Crystal structures and vibrational and solid-state (CPMAS) NMR spectroscopic studies in the tris(triphenylphosphine)-copper(I) and -silver(I) formate systems" J. CHEM. SOC., TRANS., Bd. 5, 2000, Seiten 753-761, XP008053157
- B. HAMMOND, F.H. JARDINE, A.G. VOHRA: "Carboxylatocopper(I) complexes" J. INORG. NUCL. CHEM., Bd. 33, 1971, Seiten 1017-1024, XP002347077
- C. BIANCHINI, C.A. GHILARDI, A. MELI, S.MIDOLLINI, A. ORLANDINI: "Reactivity of Copper(I) tetrahydroborates toward CO2 and COS. Structure of (triphos)Cu(n1-O2CH)" INORG. CHEM, Bd. 24, Nr. 6, 1985, Seiten 924-931, XP002347078
- B. BEGUIN, B. DENISE, R.P.A. SNEEDEN: "Hydrocondensation of CO2. II. Reaction of carbon dioxide and carbon monoxide with [HCuPPh3]" J. OF ORGANOMET. CHEM., Bd. 208, 1981, Seiten C18-C20, XP002347079 in der Anmeldung erwähnt
- N. MARSICH, A. CAMUS, G. NARDIN: "Reaction of carbon dioxide with arylcopper(I) complexes containing tertiary phosphines" J. ORGANOMETAL. CHEM., Bd. 239, 1982, Seiten 429-437, XP002347080 in der Anmeldung erwähnt
- C. BIANCHINI, C.A. GHILARDI, A. MELLI, S. MIDOLLINI, A. ORLANDINI: "Facile reduction of carbon dioxide, carbonyl sulfide and carbon disulfide by copper(I) borohydride. X-ray crystal structure of the complex [(triphos)Cu(O2CH)]" J. ORGANOMETAL. CHEM., Bd. 248, 1983, Seiten C13-C16, XP002347081 in der Anmeldung erwähnt
- MJ. MOUCHE, JL. MERMET, M. ROMAND, M. CHARBONNIER: "Metal-organic chemical vapor deposition of copper using hydrated copper formate as a new precursor" THIN SOLID FILMS, Bd. 262, 1995, Seiten 1-6, XP002347082 in der Anmeldung erwähnt

## Beschreibung

Die vorliegende Erfindung betrifft Kupfer(I)formiatkomplexe. Kupferkomplexe werden aufgrund ihrer Eigenschaft, unter Abscheidung metallischen Kupfers zu zerfallen, beispielsweise zur Abscheidung von Kupferleiterbahnen mittels Abscheidung aus der Gasphase ("chemical vapour deposition", kurz "CVD") oder aus einer Lösung ("Spincoating"-Verfahren) in der Mikroelektronik verwendet. Derartige Abscheideverfahren können alternativ zum üblichen sogenannten "Sputtern" von Kupfer (ein Verfahren zur "physical vapour deposition", kurz "PVD", bei dem keine Stoffumwandlung stattfindet) oder auch zum Aufbringen von Kupferkeimen, die zu einer verbesserten Abscheidung und Haftung anschließend aufgesputterter Kupferschichten führen, eingesetzt werden.

T.T. Kodas und M.J. Hambden-Smith geben in "The Chemistry of Metal CVD" (WileyVCH Verlag GmbH & Co. KGaA, Weinheim 1994, ISBN 3-527-29071-0), auf Seiten 239-302 einen Überblick über bekannte CVD-Verfahren zur Abscheidung von Kupfer und über gängige Einsatzstoffe dafür. Dies sind insbesondere Kupfer(II)-β-diketonat-Komplexe, Kupfer(I)-β-diketonat-Komplexe, Kupfer(I)-β-ketimid-Komplexe, Kupfer(I)-β-diimid-Komplexe, Kupfer(I)-cyclopentadien-Komplexe und Kupferalkoxide. Am häufigsten werden aufgrund ihrer Stabilität, Handhabbarkeit, Verfügbarkeit und ihrem Preis die Diketonate verwendet, deren größter Nachteil ihre vergleichsweise niedrige Kupferausbeute ist, die ohne Einsatz zusätzlicher Reduktionsmittel bei höchstens 50 % liegt. Ein alternatives Verfahren zur Kupferabscheidung, das sogenannte Spin-coating oder Spin-on-Verfahren, bei dem eine Lösung einer nicht verdampfbaren, aber zersetzlichen Kupferverbindung oder eine Kupferdispersion auf ein sich drehendes Substrat aufgebracht wird, sich durch die Drehung verteilt, und so ein gleichmäßiger Kupferfilm abgeschieden wird, beschreiben beispielsweise D.K. Sohn, S.C. Park, S.W. Kang und B.T. Ahn in J. Electrochem. Soc. 144 (1977) 3592-3596.

Es sind allgemein Kupferverbindungen oder Kupferkomplexe mit Carboxylaten oder auch Alkoxilaten bekannt, die auch zur Abscheidung von metallischem Kupfer verwendet werden können. F.A. Cotton, E.V. Dikarev und M.A. Terukhina beschreiben in Inorg. Chem. 39 (2000) 6072-6079 Kupfer(I)- und Kupfer(II)-trifluoracetat. Kupfer(I)-trifluoracetat ist sublimierbar und wäre daher prinzipiell als Einsatzstoff zur CVD geeignet. E. Iljina, A. Korjeva, N. Kuzmina, S. Troyanov, K. Dunaeva und L. Martynenko offenbaren in Mater. Sci. Eng. B18 (1993) 234-236 die Darstellung und die Kristallstruktur des flüchtigen Kupfer(II)pivalats. S. A. Krupoder, V.S. Danilovich, A.O. Miller und G.G. Furin berichten in J. Fluorine Chem. 73 (1995) 13-15 über die Synthese von und thermogravimetrische Untersuchungen an flüchtigen Kupfer(II)bis(trifluoracetat)-Komplexen. M.E. Gross beschreibt in J. Electrochem. Soc. 138 (8) (1991) 2422-2426 (teil)fluorierte Kupfer(I)alkoxide und vergleicht ihre Flüchtigkeit mit (Cyclopentadienyl)(triethylphosphino)Kupfer(I) und Carbonyl-Kupfer(I)tert.-butoxid sowie dem technisch gängigsten CVD-Einsatzstoff, Bis(hexafluoracetylacetonat)Kupfer(II).
CN 12 40 689 A offenbart die Herstellung außerordentlich feinen Kupferpulvers durch Thermolyse von Carboxylaten. JP 06/184 749 lehrt die Herstellung von Kupferfilmen durch Zersetzung von tert.-Butoxikupfercarbonyl. WO 01/13 426 A1 beschreibt die Verwendung von Kupfer(II)-bis-(2-ethylhexanoat), Kupfer(II) (2-ethylhexanoat)isopropoxid und Kupfer(II)(2-ethylhexanoat)methoxiethoxid zur Kupferabscheidung.
DE 41 38 722 A1 offenbart ein Verfahren zur Verdampfung von Kupfer(II)tetramethylheptandionat mit Hilfe von Benzylalkohol. EP 976 847 A2 lehrt die Erzeugung eines Kupferfilms aus Kupfer(II)bis(2-ethylhexanoat). DE 39 22 233 A1 beschreibt die Erzeugung von Kupfer-Leiterbahnen aus Kupfer(II)carboxylaten durch Laserbestrahlung. WO 01/94 291 A1 offenbart Kupfer(II) Komplexe des Typs Cu(OCCF₃R¹CH₂NHR²)₂ mit R¹ = Wasserstoff, C₁-C₄-Alkyl oder C₁-C₄-Perfluoralkyl und R²= C₁-C₆-Alkyl oder C₁-C₆-Alken, das wahlweise auch durch Fluor, Alkoxi- oder Alkylaminogruppen substituiert sein kann, und ihre Verwendung zur Abscheidung von Kupferfilmen. Die ältere deutsche Patentanmeldung mit dem Aktenzeichen DE 10325243.6 (angemeldet am 03.06.2003) beschreibt die Abscheidung von Kupferschichten auf Substraten durch Inkontaktbringen des Substrats mit einer Verbindung aus Kupfer(II)formiat und Alkoxialkylaminen der Formel R¹O(CH₂)ₙCHR²NH₂, wobei R¹ Methyl oder Ethyl, R² Wasserstoff oder Methyl bedeuten und n für 1, 2, 3, oder 4 steht. K. Köhler, J. Eichhorn, F. Meyer und D. Vidovic berichten in Organometallics 22 (2003) 4426-4432 über Di-Kupfer(I)oxalatkomplexe mit Alkin- der Alkenliganden und deren Verwendung zur Kupferabscheidung aus Lösung mittels spin-coating oder durch Aufsprühen einer Lösung unter Zersetzung ("aerosol assisted CVD" oder kurz "AACVD"). Aus J. Chem. Soc. Trans. Bd. 5, 2000, 753 - 761 sind Kupfer(I)formiatkomplexe mit Phosphanliganden der Formel Ph₃P bekannt. Diese werden durch Umsetzung von Kupfer(I)formiat mit Ligand L und wahlweise Ameisensäure hergestellt.

Es sind auch spezifisch Kupfer(II)formiate und die Abscheidung von metallischem Kupfer durch Zersetzung solcher Verbindungen bekannt. J.-K Kim, S.-K. Park und C. Lee beschreiben in J. Korean Phys. Soc. 35(5) (1999) 426-430 die Verwendung von Kupfer(II)formiat-Tetrahydrat zur Erzeugung von Mikrostrukturen durch laserinduzierte Kupferabscheidung. M.-J. Mouche, J.-L. Mermet, C. Mathon und R. Cimard berichten in Adv. Sci. Technol. (Adv. Inorg. Films and Coatings) 5 (1995) 231-238 wie auch M.-J. Mouche, L. Mermet, M. Romand und M. Charbonnier in Thin Solid Films 262 (1995) 1-6 über die Verwendung von Kupfer(II)formiathydrat als Einsatzstoff für CVD in einem Trägergas. R. Padiyath, M. David und S.V. Babu beschreiben in Metallized Plastics 2 (1991) 113-120 über die Erzeugung von Kupferfilmen aus Kupfer(II)formiat in einem Wasserstoffplasma. R. Padiyath, J. Seth, S.V. Babu und L.J. Matienzo berichten in J. Appl. Phys. 73(5) (1993) 2326-2332 über die Abscheidung von Kupfer auf Silizium und die Bildung von Kupfersilizid durch Aufbringung von Kupferformiat und Reduktion in einem Wasserstoffplasma. J.-K. Kim und C. Lee berichteten im Januar 1999 auf der SPIE Conference on Laser Applications in Microelectronic and Optoelectronic Manufacturing IV, San Jose, Kalifornien, USA (vgl. Proceedings SPIE-Int. Soc. Opt. Eng. 3618 (1999) 378-385) über die Erzeugung von Kupferfilmen aus Kupfer(II)formiat durch Bestrahlung mit einem Argonlaser. EP 1 077 084 A2 offenbart im dortigem Beispiel 24 die Abscheidung von Kupfer auf Mordenit durch thermische Zersetzung von Kupferformiat. EP 368 231 A2 beschreibt die Abscheidung von Kupfer durch Thermolyse von Kupfer(II)formiat auf Harz-Formteilen. Im Verfahren von US 5 141 602 A wird Kupfer durch Zersetzung von Kupfer(II)formiat mittels Laserbestrahlung abgeschieden und im Verfahren von JP 11/193 461 A wiederum durch thermische Zersetzung.

WO 03/053 895 beschreibt Kupferformiertkomplex aus einem aromatischen stickstoffheterozyklischen Liganden für die Abscheidung von metallischen Kupfer.

A. Keller und F. Körösy berichten in Nature 162 (1948) 580-582 über die Zersetzung von Kupfer(I)formiat, das sie als CuHCOO beschreiben und durch vorsichtige Zersetzung von Kupfer(II)formiat herstellen, zu Kupfer, Kohlendioxid und Wasserstoff beim Erhitzen auf 105 °C. D.A. Edwards und R. Richards beschreiben in J. Chem. Soc. Dalton Trans. 1973, 2463-2468 die Synthese von Kupfer(I)formiat durch Umsetzung von Kupfer(II)formiat mit metallischem Kupfer in Ameisensäure. Kupfer(I)formiate sind ansonsten vor allem in Form ligandenstabilisierter Komplexe bekannt, üblicherweise des Typs LₙCu(HCOO), wobei Lₙ entweder einen mindestens zweizähnigen Liganden L (n = 1) oder (n = 2, 3 oder 4) 2, 3 oder 4 mindestens einzähnige Liganden L darstellt. B. Beguin, B. Denise und R.P.A. Sneeden beschreiben in J. Organomet. Chem. 208 (1981) C18-C20 den Kupfer(I)formiatkomplex (PPh₃)₂Cu(HCOO), der aus [HCuPPh₃]₆, PPh₃ und CO₂ hergestellt wird. N. Marisch, A. Camus und G. Nardin berichten in J. Organomet. Chem. 239 (1982) 429-437 über die Kristallstruktur von (PPh₃)₂Cu(HCOO) und seine Pyrolyse bei 200 °C, wobei er im wesentlichen zu Kupfer, CO₂ und PPh₃ zerfällt. C. Bianchini, C.A. Ghilardi, A. Meli, S. Midollini und A. Orlandini beschreiben in J. Organomet. Chem. 248 (1983) C13-C16 die Synthese und die Struktur von (triphos)Cu(HCOO) mit triphos = 1,1,1-tris(diphenylphosphinomethyl)ethan. Hergestellt wird dieser Komplex durch Umsetzung von (triphos)Cu(BH)₄ mit CO₂.G. Doyle, K.A. Eriksen, M. Modrick und G. Ansell berichten in Organometallics 1 (1982) 1613-1618 über die Synthese des Komplexsalzes [(tmeda)Cu₂(CO)(HCOO)]⁺ [BPh₄]⁻ (tmeda = N,N,N',N'-Tetramethylethylendiamin, Ph = Phenyl) aus tmeda, Kupfer(I)oxid, Kohlenmonoxid, Ameisensäure und Natriumtetraphenylboranat. Alle diese Kupfer(I)formiate sind in kleinsten Mengen zu rein wissenschaftlichen Zwecken hergestellte Verbindungen, deren Zersetzung zum Zwecke der Kupferabscheidung allein schon aufgrund der umständlichen Herstellung aus wirtschaftlichen Gründen nie in Rede stand.

Es besteht weiterhin Bedarf an Kupferverbindungen, die zur Verwendung als Einsatzstoff zur Abscheidung von metallischem Kupfer mittels CVD besser geeignet sind als bekannte Verbindungen. Wesentliche Anforderungen sind ein hoher Kupfergehalt, leichte Zugänglichkeit, geringe Kosten, hohe Stabilität bei Handhabung und Lagerung, jedoch leichter Zerfall während der Beschichtung des Substrats, wobei jedoch neben Kupfer keine nicht flüchtigen Verunreinigungen entstehen sollen, da diese auf dem Substrat abgeschieden würden. Aufgabe der vorliegenden Erfindung ist es, derartige Kupferverbindungen und Verfahren zu Ihrer Herstellung und zur Abscheidung von Kupfer durch ihre Zersetzung zu finden.

Diese Aufgabe wird gemäß der vorliegenden Erfindung durch die Merkmale der unabhängigen Ansprüche 1, 6, 8, 9 und 13 gelöst. Demgemäß wurden Kupfer(I)formiatkomplexe der allgemeinen Formel LₙCu(HCOO) x HCOOH gefunden. wobei x eine Zahl von 0 bis 10 ist, n 1, 2, 3 oder 4 beträgt und die n Liganden L unabhängig voneinander jeweils einen der folgenden Liganden bedeuten:
- ein Phosphan der Formel R¹R²R³P,;
   wobei R¹, R², und R³ unabhängig voneinander Wasserstoff, einen linearen oder verzweigten, wahlweise teilweise oder vollständig fluorierten Alkyl-, Aminoalkyl-, Alkyoxyalkyl-, Hydroxy alkyl-, Phosphinoalkylrest mit einem bis 20 Kohlenstoffatomen bedeuten;
   oder
- ein Phosphit der Formel (R¹O)(R²O)(R³O)P,;
- ein Isocyanid der Formel R¹-NC,;
- ein Alken der allgemeinen Formel R¹R²C=CR³R⁴,; oder
- ein Alkin der allgemeinen Formel R¹C≡CR²,;
   wobei R¹, R², R³ und R⁴ unabhängig voneinander Wasserstoff, einen linearen oder verzweigten, wahlweise teilweise oder vollständig fluorierten Alkyl-, Aminoalkyl-, Alkyoxyalkyl-, Hydroxyalkyl-, Phosphinoalkyl- oder Arylrest mit einem bis 20 Kohlenstoffatomen bedeuten.

Ferner wurden Verfahren zur Herstellung dieser erfindungsgemäßen Kupfer(I)formiatkomplexe gefunden, ein Verfahren zur Herstellung des Ausgangsstoffs Kupfer(I)formiat für eines dieser Verfahren, und Verfahren zur Abscheidung von Kupfer durch Zersetzung der Kupfer(I)formiatkomplexe.

Die erfindungsgemäßen Kupfer(I)formiatkomplexe haben die allgemeine Formel LₙCu(HCOO) · x HCOOH. Derartige Kupfer(I)formiatkomplexe können auch als polynukleare Komplexe vorliegen, formal also als Oligomere [LₙCu(HCOO) · x HCOOH]ₘ, wobei m eine ganze Zahl und mindestens 2 ist. Ob die erfindungsgemäßen Komplexe sich zu polynuklearen Komplexen zusammenlagern, hängt im wesentlichen vom Ligand L ab.

Die Zahl x in der obigen allgemeinen Formel ist eine Zahl, die gleich Null sein kann, jedoch typischerweise im Allgemeinen mindestens 0,1, in bevorzugter Form mindestens 0,5 und in besonders bevorzugter Form mindestens 1 sowie im Allgemeinen höchstens 10, in bevorzugter Form höchstens 5 und in besonders bevorzugter Form höchstens 2 beträgt. In ganz besonders bevorzugter Form beträgt x 1

In der allgemeinen Formel bedeutet n 1, 2, 3 oder 4. Vorzugsweise bedeutet n 2 oder 3. L bedeutet einen der folgenden Liganden, die, wenn n größer als 1 ist, unabhängig voneinander gewählt werden:
- ein Phosphan der Formel R¹R²R³P;
- ein Phosphit der Formel (R¹O)(R²O)(R³O)P;
- ein Isocyanid der Formel R¹-NC;
- ein Alken der allgemeinen Formel R¹R²C=CR³R⁴; oder
- ein Alkin der allgemeinen Formel R¹C¹≡CR²;
   wobei R¹, R², R³ und R⁴ jeweils unabhängig voneinander bedeuten:
- Wasserstoff oder
   einen linearen oder verzweigten, wahlweise teilweise oder vollständig fluorierten Alkyl-, Aminoalkyl-, Alkoxialkyl-, Hydroxialkyl-, Phosphinoalkyl- oder, wenn L kein Phosphan der Formel R¹R²R³ ist, Arylrest mit einem bis 20 Kohlenstoffatomen.

Beispiele derartiger linearer oder verzweigter Alkylreste sind die Methyl-, Ethyl-, n-Propyl-, iso-Propyl-, n-Butyl-, sec.-Butyl-, iso-Butyl-, tert.-Butyl-, und 2-Ethylhexyl-Reste, die isomeren Pentyl-, Hexyl-, Heptyl-, Octyl,-, Nonyl, Decyl-, Undecyl oder Dodecylreste und die cyclischen Alkylreste wie etwa Cyclopropyl-, Cyclobutyl-, Cyclopentyl-, Cyclohexyl-, Cycloheptyl-, Cyclooctyl- und Bicyclononylreste, die auch Alkylsubstituenten tragen können. Statt mit Wasserstoff können die Kohlenstoffatome auch andere Substituenten tragen, beispielsweise Halogensubstituenten, insbesondere Fluor. Zwei oder mehr der Reste können auch ein geschlossenes Ringsystem bilden, das auch ungesättigt sein kann. Ein Beispiel für einen derartigen Liganden L ist Cyclopentadienyl, das formal ein Olefin R¹R²C=CR³R⁴ ist.

Beispiele solcher Aminoalkyl-, Alkoxialkyl-, Hydroxialkyl-, und Phosphinoalkylreste sind die mit einer oder mehreren Aminogruppen, Alkylaminogruppen, Alkoxigruppen, Hydroxigruppen, Phosphinoalkyl und/oder Alkylphospinoalkylresten substituierten genannten Alkylreste.

Beispiele solcher Arylreste sind Phenyl- und Naphthylreste, die auch mit den genannten Alkyl-, Aminoalkyl-, Alkoxialkyl-, Hydroxialkyl-, und Phosphinoalkylresten substituiert sein können.

Vorzugsweise sind die Liganden L unabhängig voneinander jeweils ein Phosphan der Formel R¹R²R³P; ein Phosphit der Formel (R¹O)(R²O)(R³O)P oder ein Isocyanid der Formel R¹-NC.

Bevorzugte Reste Rⁿ (n = 1, 2, oder 3) sind die Methyl-, Ethyl-, iso-Propyl-, n-Butyl-, tert.-Butyl-, Cyclopentyl- und Cyclohexylreste.

Besonders bevorzugte Liganden sind die Trialkylphosphinreste wie Trimethylphosphin, Triethylphosphin, Tri-iso-propylphosphin, Tri-n-butylphosphin, Tri-iso-butylphosphin, Tricyclopentylphosphin, die Trialkylphosphitreste wie Trimethoxiphosphin, Triethoxiphosphin, Tri-iso-propoxiphosphin und Tri(2,2,2-Trifluorethoxi)phosphin und die Alkylisocyanide wie iso-Propylisocyanid, n-Butylisocyanid, tert.-Butylisocyanid und Cyclohexylisocyanid. Tri-n-butylphosphin ist ein ganz besonders bevorzugter Ligand.

Triphenylphosphin und 1,1,1-Tris(diphenylphosphinomethyl)ethan sind aus der allgemeinen Formel der erfindungsgemäßen Kupfer(I)formiatkomplexe ausgenommen.

Es wurden drei Verfahren zur Herstellung der erfindungsgemäßen Kupfer(I)formiatkomplexe gefunden.

Das erste derartige erfindungsgemäße Verfahren geht von Kupfer(I)formiat aus. Verfahren zur Herstellung von Kupfer(I)formiat sind bekannt. Kupfer(I)formiat wird dabei in einem trockenen, inerten Lösungsmittel durch Zugabe der gewünschten stöchiometrischen Menge des oder der Liganden L zu den erfindungsgemäßen Kupfer(I)formiatkomplexen umgesetzt. Als inertes Lösungsmittel sind alle inerten Lösungsmittel geeignet. Insbesondere sind aprotische polare Lösungsmittel geeignet. Beispiele geeigneter Lösungsmittel sind Ether wie etwa Diethylether, Dipropylether, Dibutylether, Tetrahydrofuran, tert-Butylmethylether oder tert.-Butylethylether und halogenierte, insbesondere chlorierte Alkanlösungsmittel wie Methylenchlorid und Chloroform. Bevorzugt werden Tetrahydrofuran oder Methylenchlorid verwendet. Zur Durchführung der Umsetzung wird bequemerweise das Kupfer(I)formiat in Lösung oder als Suspension vorgelegt und eine Lösung von n Moläquivalenten des oder der Liganden unter Rühren zugegeben. Der Kupfer(I)formiatkomplex wird anschließend gewonnen, beispielsweise durch Kristallisation, wahlweise auch durch Entfernen des Lösungsmittels, etwa durch Abdampfen im Vakuum oder durch Kristallisation nach teilweisem Entfernen des Lösungsmittels. Komplexe, die nach diesem Verfahren hergestellt werden, enthalten in der Regel keine von Ameisensäure (x = 0), falls gewünscht, kann jedoch eine entsprechende Menge Ameisensäure bei der Synthese zugesetzt werden.

Es wurde im Rahmen der vorliegenden Erfindung auch ein Verfahren zur Herstellung der erfindungsgemäßen Kupfer(I)formiatkomplexe gefunden, bei dem das wenig stabile ligandenfreie Kupfer(I)formiat nicht isoliert und als Substanz gehandhabt werden muss. Bei diesem Verfahren wird wasserfreies Kupfer(II)formiat mit metallischem Kupfer (üblicherweise in stöchiometrischem Überschuss eingesetzt, beispielsweise als Draht, Dispersion, Granalien oder Folie) und einem Moläquivalent Ameisensäure umgesetzt, wahlweise in einem inerten Lösungsmittel. Als inertes Lösungsmittel sind alle inerten Lösungsmittel geeignet, insbesondere aprotische polare Lösungsmittel. Beispiele geeigneter Lösungsmittel sind Ether wie etwa Diethylether, Dipropylether, Dibutylether, Tetrahydrofuran, tert-Butylmethylether oder tert.-Butylethylether, halogenierte, insbesondere chlorierte Alkanlösungsmittel wie Methylenchlorid und Chloroform und Acetonitril. Bevorzugt wird Acetonitril verwendet. Die Reaktionsmischung wird reagieren gelassen, bis die Umsetzung beendet ist, was im Allgemeinen nach mindestens einer Stunde, vorzugsweise mindestens 2 Stunden und in besonders bevorzugter Form nach mindestens 4 Stunden Reaktionsdauer sowie im Allgemeinen nach höchstens 48 Stunden, vorzugsweise nach höchstens 36 Stunden und in besonders bevorzugter Form nach höchstens 30 Stunden Reaktionsdauer der Fall ist. Anschließend wird der gewünschte Ligand L in der gewünschten stöchiometrischen Menge zugegeben und die Reaktionsmischung bis zum Abschluss der Komplexbildung weiter reagieren gelassen. Im Allgemeinen ist die Komplexbildung nach mindestens fünf Minuten, vorzugsweise mindestens 10 Minuten und in besonders bevorzugter Form nach mindestens 30 Minuten Reaktionsdauer sowie im Allgemeinen nach höchstens 6 Stunden, vorzugsweise nach höchstens 4 Stunden und in besonders bevorzugter Form nach höchstens 2 Stunden beendet. Anschließend wird der Feststoff (im wesentlichen unumgesetztes Kupfer) abgetrennt, das Lösungsmittel entfernt und so das Produkt gewonnen. Bei dieser Form der Herstellung der erfindungsgemäßen Kupfer(I)formiatkomplexe enthält der hergestellte Komplex Ameisensäure, deren Menge sich dem gewählten Liganden L und seinem Anteil n gemäß einstellt.

Ferner können manche der erfindungsgemäßen Kupfer(I)formiatkomplexe LₙC(HCOO), nämlich die, deren Halogenidanaloga, insbesondere Chloridanaloga LₙCuX mit X = Halogenid, z. B. Cl, bekannt sind, durch Umsetzung dieser Halogenidkomplexe mit Ameisensäure und einer Base hergestellt werden. Dazu wird der Halogenidkomplex in einem Lösungsmittel mit der gewünschten stöchiometrischen Menge Ameisensäure versetzt. Die stöchiometrische Menge Ameisensäure ist mindestens so hoch wie die Menge des Halogenidkomplexes. Wenn ein Ameisensäure enthaltender erfindungsgemäßer Kupfer(I)komplex (d.h. mit x > 0) hergestellt werden soll, wird die stöchiometrische Menge Ameisensäure entsprechend gewählt. Als inertes Lösungsmittel sind insbesondere alle solchen inerten Lösungsmittel geeignet, in denen entweder das aus Base und Halogenid gebildete Nebenprodukt besser löslich ist als der Kupfer(I)formiatkomplex, oder umgekehrt. Insbesondere sind aprotische polare Lösungsmittel geeignet. Beispiele geeigneter Lösungsmittel sind Ether wie etwa Diethylether, Dipropylether, Dibutylether, Tetrahydrofuran, tert-Butylmethylether oder tert.-Butylethylether und halogenierte, insbesondere chlorierte Alkanlösungsmittel wie Methylenchlorid und Chloroform. Bevorzugt wird ein Ether, insbesondere tert-Butylmethylether verwendet; in diesen Fällen wird zumeist der Kupfer(I)formiatkomplex besser gelöst als das Nebenprodukt. Im Allgemeinen ist der Austausch des Halogenids gegen Formiat nach mindestens fünf Minuten, vorzugsweise mindestens 10 Minuten und in besonders bevorzugter Form nach mindestens 30 Minuten Reaktionsdauer sowie im Allgemeinen nach höchstens 6 Stunden, vorzugsweise nach höchstens 4 Stunden und in besonders bevorzugter Form nach höchstens 2 Stunden beendet. Das Halogenid wird nun durch Zugabe einer Base gefällt. Als Basen eignen sich insbesondere primäre, sekundäre oder tertiäre Amine, beispielsweise und vorzugsweise Triethylamin. Die Reaktionsmischung wird nach Basenzugabe weiter reagieren gelassen, im Allgemeinen für mindestens eine Stunde, vorzugsweise mindestens 2 Stunden und in besonders bevorzugter Form mindestens 4 Stunden Reaktionsdauer sowie im Allgemeinen höchstens 12 Stunden, vorzugsweise höchstens 8 Stunden und in besonders bevorzugter Form höchstens 6 Stunden. Anschließend werden Produkt und Nebenprodukt getrennt. Ist das Produkt im verwendeten Lösungsmittel besser löslich als das Nebenprodukt, wird abfiltriert und anschließend wird das Lösungsmittel entfernt. Der getrocknete Rückstand kann zur weiteren Reinigung in einem Extraktionsmittel aufgenommen, und dieses anschließend wiederum vom Feststoff befreit werden. Als Extraktionsmittel eignen sich alle Lösungsmittel, in denen zwar der erfindungsgemäße Kupfer(I)formiatkomplex, nicht jedoch das als Nebenprodukt gebildete Umsetzungsprodukt von Halogenwasserstoff mit der Base löslich ist. Insbesondere sind aprotische unpolare oder wenig polare Lösungsmittel geeignet. Beispiele geeigneter Lösungsmittel sind Alkane oder aromatische Kohlenwasserstoffe wie etwa Pentan, Hexan, Benzin, Petroleum, Benzol oder Toluol. Bevorzugt wird Hexan verwendet. Das Extraktionsmittel wird im Anschluss an die Entfernung von Feststoffen entfernt und so das Produkt gewonnen. Ist dagegen das Produkt im gewählten Lösungsmittel schlechter löslich als das Nebenprodukt, wird es abfiltriert, falls nötig nach Einengen des Lösungsmittels.

Auf die gleiche Weise kann auch ligandenfreies Kupfer(I)formiat aus Kupfer(I)-halogenid, insbesondere Kupfer(I)chlorid, durch dessen Umsetzung mit Ameisensäure und einer Base gewonnen werden.

Die Reaktionstemperatur bei diesen Umsetzungen und auch die bei der Entfernung des Lösungsmittels angewandte Temperatur sollte so hoch sein, dass die Umsetzung oder Lösungsmittelentfernung in befriedigender Geschwindigkeit abläuft, jedoch nicht so hoch, dass die Zersetzung des Kupfer(I)formiats beginnt. Im Allgemeinen wird eine Temperatur von mindestens -20 °C, vorzugsweise mindestens 0 °C und in besonders bevorzugter Weise mindestens 10 °C sowie im Allgemeinen höchstens 80 °C, vorzugsweise höchstens 60 °C und in besonders bevorzugter Weise höchstens 40 °C eingestellt. Es kann meist problemlos bei Raumtemperatur, also im Bereich von 20 °C bis 25 °C gearbeitet werden, die Lösungsmittelentfernung ist gegebenenfalls unter vermindertem Druck durchzuführen, um befriedigende Geschwindigkeiten zu erreichen.

In allen Fällen werden die Synthesen bevorzugt unter Ausschluss von Luft, insbesondere Sauerstoff durchgeführt. Es wird mit üblichen Schutzgastechniken gearbeitet. Als Schutzgas eignen sich übliche Inertgase, insbesondere Stickstoff oder Argon. Ebenso bevorzugt wird so weit wie möglich in wasserfreier Umgebung gearbeitet.

Die erfindungsgemäßen Kupfer(I)formiatkomplexe werden durch bekannte Verfahren wie CVD, AACVD oder spin-coating auf Substrate aufgebracht und dabei oder danach thermisch unter Kupferabscheidung zersetzt. Dabei entstehen geschlossene Kupferfilme. Bei der AACVD und beim Spin-Coating werden die erfindungsgemäßen Kupfer(I)formiatkomplexe vorzugsweise in Form einer Lösung in einem inerten Lösungsmittel verwendet. Als inertes Lösungsmittel sind alle Lösungsmittel geeignet, in denen sich der verwendete erfindungsgemäße Kupfer(I)formiatkomplex ausreichend löst und die unter den angewendeten Bedingungen auch gegenüber dem Substrat inert sind. Sie sollten auch möglichst leicht verdampfbar und so einfach entfernbar sein. Beispiele geeigneter Lösungsmittel sind polare oder unpolare aprotische Lösungsmittel wie etwa Ether wie Diethylether, Dipropylether, Dibutylether, Tetrahydrofuran, tert-Butylmethylether oder tert.-Butylethylether und halogenierte, insbesondere chlorierte Alkanlösungsmittel wie Methylenchlorid und Chloroform, Alkane und aromatische Kohlenwasserstoffe wie Pentan, Hexan, Benzin, Petroleum, Benzol oder Toluol. Die Konzentration der Lösung an Formiatkomplex wird so gewählt, dass die Viskosität der Lösung eine einfache Handhabung erlaubt und dass gleichmäßige Kupferfilme entstehen. Im Allgemeinen wird eine Lösung verwendet, die mindestens 0,5 Gew.-%, vorzugsweise mindestens 3 Gew.-% und in besonders bevorzugter form mindestens 5 Gew.-% sowie im Allgemeinen höchstens 40 Gew.-%, vorzugsweise höchstens 30 Gew.-% und in besonders bevorzugter Form höchstens 20 Gew.-% des Kupfer(I)formiatkomplexes enthält.

Zur Aufbringung mittels AACVD wird üblicherweise der Komplex oder eine Lösung des Komplexes auf das geheizte Substrat gesprüht oder das besprühte Substrat anschließend auf Zersetzungstemperatur geheizt. Zur Aufbringung mittels Spin-Coating wird üblicherweise der Komplex oder eine Lösung des Komplexes auf das sich drehende Substrat aufgebracht, so dass durch die Fliehkraft eine gleichmäßige Schicht der Flüssigkeit erzeugt wird. Das Substrat wird während des Aufbringens oder anschließend auf die Zersetzungstemperatur geheizt.

Zur Abscheidung einer Kupferschicht auf einem Substrat durch Zersetzung eines erfindungsgemäßen Kupfer(I)formiatkomplexes wird das Substrat während der Aufbringung des Komplexes oder unmittelbar danach auf eine Temperatur oberhalb der Zersetzungstemperatur des Komplexes erwärmt. Im allgemeinen wird auf eine Temperatur von mindestens 80 °C, vorzugsweise mindestens 100 °C und in besonders bevorzugter Form mindestens 105 °C sowie im Allgemeinen höchstens 300 °C, vorzugsweise höchstens 280 °C und in besonders bevorzugter Form höchstens 250 °C erwärmt.

### Beispiele

### Beispiel 1: Herstellung von Kupfer(I)formiat

Zu einer Suspension von 1,98 g Kupfer(I)chlorid CuCl (20 mMol) in 40 ml trockenem Methylenchlorid wurde unter Rühren unter Stickstoff innerhalb von 5 Minuten bei Raumtemperatur eine Lösung von 0,92 g Ameisensäure (20 mMol) in 20 ml Methylenchlorid gegeben. Nach 10 Minuten wurden 2,02 g wasserfreies Triethylamin (20 mMol) zugegeben. Die Mischung wurde für weitere 4 Stunden gerührt, anschließend wurde der gebildete blassgrüne Niederschlag aus Kupfer(I)formiat über eine Umkehrfritte abfiltriert und mit 20 ml Methylenchlorid gewaschen. Die Ausbeute betrug 95 Mol-%.

### Beispiel 2: Herstellung der erfindungsgemäßen Komplexe aus Kupfer(I)formiat und Ligand

Eine Lösung von n Äquivalenten des Liganden (1 Äquivalent zu je 8,3 mMol) wurde in 20 ml trockenem Methylenchlorid oder Tetrahydrofuran langsam unter Stickstoff zu einer gerührten Suspension von 8,3 mMol Kupfer(I)formiat in 20 ml Methylenchlorid oder THF gegeben. Nach jeweils etwa einer Stunde war das Kupfer(I)formiat vollständig gelöst. Nach Abziehen des Lösungsmittels im Vakuum erhielt man die Kupfer(I)formiatkomplexe als farblose Öle oder Feststoffe.

### Beispiel 3: Herstellung der erfindungsgemäßen Komplexe aus Kupfer(I)chloridkomplexen

Eine Lösung von 0,1 Mol eines Kupfer(I)chlorids der Formel LₙCuCl in 200 ml Methyltert.-butyl-ether wurde bei 0 °C unter Rühren mit 4,6 g (0,1 Mol) Ameisensäure versetzt und für eine Stunde weiter gerührt. Anschließend wurden 10,1 g (0,1 Mol) wasserfreies Triethylamin zugegeben und für 5 Stunden bei Raumtemperatur gerührt. Danach wurde das Lösungsmittel bei 40 °C im Vakuum entfernt und der feste Rückstand zweimal mit je 100 ml Hexan extrahiert. Die vereinigten Extrakte wurden bei 40 °C im Vakuum vom Hexan befreit und so das Produkt gewonnen.

### Beispiel 4: Herstellung eines erfindungsgemäßen Komplexes ohne Isolierung intermediär gebildeten Kupfer(I)formiats

1,53 g wasserfreies Kupfer(II)formiat Cu(HCOO)₂ (10 mMol), 1,6 g 98%ige Ameisensäure und 2,7 g Kupferfolie wurden für 24 Stunden unter Stickstoff in 60 ml wasserfreiem Acetonitril gerührt. Dabei bildete sich eine farblose Lösung über unumgesetztem festen Kupfer. 6,65 g Triethoxiphosphan (40 mMol) wurden anschließend tropfenweise zugefügt. Die Reaktionsmischung wurde für eine weitere Stunde gerührt und anschließend die Kupferfolie abfiltriert. Das Produkt [(H₃CH₂CO)₃P]₂Cu(HCOO) ·x HCOOH wird durch Einengen des Filtrats als farblose Flüssigkeit gewonnen.

Die nach diesen Methoden als Beispiele hergestellten Kupfer(I)formiatkomplexe LₙCu(HCOO) · x HCOOH sind gemeinsam mit den chemischen Verschiebungen δ der Phosphinliganden im ³¹P-NMR, und denjenigen der Formiatkohlenstoffe und -protonen im ¹³C-NMR- und ¹H-NMR in der folgenden Tabelle zusammengestellt

**Tabelle**

| Ligand L | n | hergestellt nach Bsp. | Aggregatzustand | ³¹P-NMR δ [ppm] | ¹³C-NMR δ [ppm] | ¹H-NMR δ [ppm] |
|---|---|---|---|---|---|---|
| (H₃C)₃P | 2 | 2,3 | flüssig | -45,7 | 166,7 | 8,4 |
| (H₃CH₂C)₃P | 2 | 2, 3 | flüssig | -12,2 | 165,4 | 8,3 |
| | 3 | 2, 3 | flüssig | -14,4 | 164,3 | 8,5 |
| [(H₃C)₂HC]₃P | 2 | 2, 3 | flüssig | 22,1 | 167,2 | 8,3 |
| (H₃CH₂CH₂CH₂C)₃P | 2 | 2, 3 | flüssig | -25 | 165,7 | 8,4 |
| | 3 | 2, 3 | fest | -22 | 166,8 | 8,5 |
| [(H₃C)₂HCH₂C]₃P | 2 | 2, 3 | flüssig | -28,5 | 164,1 | 8,2 |
| (C₅H₉)₃P | 2 | 2, 3 | fest | 8,3 | 164,7 | 8,2 |
| | 3 | 2, 3 | fest | 9,6 | 165,2 | 8,3 |
| (H₃CO)₃P | 2 | 2, 3 | flüssig | 126,5 | 167,3 | 8,6 |
| | 3 | 2, 3 | flüssig | -126,9 | 167 | 8,6 |
| (H₃CH₂CO)₃P | 2 | 2, 3, 4 | flüssig | 122,9 | 166,6 | 8,4 |
| | 3 | 2, 3 | fest | 117,9 | 165,8 | 8,5 |
| [(H₃C)₂HCO]₃P | 2 | 2, 3 | fest | 117 | 169 | 8,2 |
| | 3 | 2, 3 | fest | 121,6 | 168,5 | 8,3 |
| (F₃CH₂CO)₃P | 2 | 2, 3 | flüssig | 119,8 | 159,5 | 8,1 |
| (C₆H₅)₃P | 2 | 2, 3 | fest | -3,3 | 169,2 | 8,5 |
| (H₃C)₂HC-NC | 2 | 2 | fest | - | 140,5 | 8,2 |
| H₃CH₂CH₂CH₂C-NC | 2 | 2 | fest | - | 140,5 | 8,2 |
| (H₃C)₃C-NC | 2 | 2 | fest | - | 129 | 8,5 |
| H₁₁C₆-NC | 2 | 2 | flüssig | - | 152,4 | 8,6 |

### Beispiel 5: Thermogravimetrische Untersuchung von [(H₃CH₂CO)₃P]₂Cu(HCOO)

Eine thermogravimetrische Untersuchung des Komplexes [(H₃CH₂CO)₃P]₂Cu(HCOO) bestätigte, dass er wie berechnet zu 14,4 Gew.-% aus Kupfer und zu 85,6 Gew.-% aus organischen Bestandteilen besteht und zeigte, dass er beim Erwärmen auf Temperaturen von mindestens 150 °C exakt 85,6 % seines ursprünglichen Gewichts verliert. Dies bestätigt, dass der Komplex zu Kupfer und ansonsten unter diesen Bedingungen ausschließlich gasförmigen sonstigen Zerfallsprodukten zerfällt.

### Beispiel 6: Abscheidung eines Kupferfilms

Eine 10 %-ige Lösung von [(H₃CH₂CO)₃P]₂Cu(HCOO) in Methylenchlorid wurde in einen auf 200 °C geheizten Glaskolben gesprüht. Es entstand ein Kupferfilm auf der Innenseite des Kolbens.

### Beispiel 7: Abscheidung eines Kupferfilms

Die Innenwand eines Glaskolbens wurde mit einer 10 %-igen Lösung von [(H₃CH₂CO)₃P]₂Cu(HCOO) in Methylenchlorid benetzt. Durch vorsichtiges Verdampfen des Lösungsmittels wurde ein dünner Film des Formiatkomplexes auf der Kolbeninnenwand erzeugt. Der Kolben wurde anschließend auf 200 °C erhitzt. Es entstand ein Kupferfilm auf der Innenseite des Kolbens.

## Patentansprüche

1. Kupfer(I)formiatkomplexe der allgemeinen Formel LₙCu(HCOO) · x HCOOH, wobei x eine Zahl von 0 bis 10 ist, n 1, 2, 3 oder 4 beträgt und die n Liganden L unabhängig voneinander jeweils einen der folgenden Liganden bedeuten:
- ein Phosphan der Formel R¹R²R³P,
wobei R¹, R², und R³ unabhängig voneinander Wasserstoff, einen linearen oder verzweigten, wahlweise teilweise oder vollständig fluorierten Alkyl-, Aminoalkyl-, Alkoxyalkyl-, Hydroxyalkyl-, Phosphinoalkylrest mit einem bis 20 Kohlenstoffatomen bedeuten;
oder
- ein Phosphit der Formel (R¹O)(R²O)(R³O)P,
- ein Isocyanid der Formel R¹-NC,
- ein Alken der allgemeinen Formel R¹R²C=CR³R⁴, oder
- ein Alkin der allgemeinen Formel R¹C≡CR²,
wobei R¹, R², R³ und R⁴ unabhängig voneinander Wasserstoff, einen linearen oder verzweigten, wahlweise teilweise oder vollständig fluorierten Alkyl-, Aminoalkyl-, Alkyoxyalkyl-, Hydroxyalkyl-, Phosphinoalkyl- oder Arylrest mit einem bis 20 Kohlenstoffatomen bedeuten.

2. Kupfer(I)formiatkomplexe nach Anspruch 1, **dadurch gekennzeichnet, dass** n gleich 2 oder 3 ist.

3. Kupfer(I)formiatkomplexe nach Anspruch 1 oder 2, **dadurch gekennzeichnet, dass** L aus der von Trimethylphosphin, Triethylphosphin, Tri-iso-propylphosphin, Tri-n-butylphosphin, Tri-iso-butylphosphin, Tricyclopentylphosphin, Trimethoxiphosphin, Triethoxiphosphin, Tri-iso-propoxiphosphin, Tri(2,2,2-Trifluorethoxi)phosphin, iso-Propylisocyanid, n-Butylisocyanid, tert.-Butylisocyanid und Cyclohexylisocyanid gebildeten Gruppe gewählt wird.

4. Kupfer(I)formiatkomplexe nach Anspruch 3, **dadurch gekennzeichnet, dass** L Tri-n-butylphosphin ist.

5. Kupfer(I)formiatkomplexe nach Anspruch 4, **dadurch gekennzeichnet, dass** x gleich 1 ist.

6. Verfahren zur Herstellung der in den Ansprüchen 1 bis 5 definierten Kupfer(I)formiatkomplexe durch Umsetzung von Kupfer(I)formiat mit Ligand L und wahlweise Ameisensäure.

7. Verfahren nach Anspruch 6, **dadurch gekennzeichnet, dass** man das Kupfer(I)formiat in einem ersten Schritt aus Kupfer(II)formiat, metallischem Kupfer und Ameisensäure gewinnt und es vor Zugabe des Liganden L nicht isoliert.

8. Verfahren zur Herstellung der in den Ansprüchen 1 bis 5 definierten Kupfer(I)formiatkomplexe durch Umsetzung eines Kupfer(I)halogenidkomplexes der Formel LₙCu(I)X, wobei X ein Halogenid ist und L sowie n die in Anspruch 1 definierten Bedeutungen haben, mit Ameisensäure und anschließend mit einer Base.

9. Verfahren zur Abscheidung metallischen Kupfers auf einem Substrat durch Aufbringung eines Kupfer(I)formiatkomplexes der allgemeinen Formel LₙCu(HCOO) · x HCOOH auf das Substrat und thermische Zersetzung des Kupfer(I)formiatkomplexes bei einer Temperatur von mindestens 80 °C, wobei x eine Zahl von 0 bis 10 ist, n 1, 2, 3 oder 4 beträgt und die n Liganden L unabhängig voneinander jeweils einen der folgenden Liganden bedeuten:
- ein Phosphan der Formel R¹R²R³P,
- ein Phosphit der Formel (R¹O)(R²O)(R³O)P,
- ein Isocyanid der Formel R¹-NC,
- ein Alken der allgemeinen Formel R¹R²C=CR³R⁴, oder
- ein Alkin der allgemeinen Formel R¹C≡CR²,
wobei R¹ R², R³ und R⁴ unabhängig voneinander Wasserstoff, einen linearen oder verzweigten, wahlweise teilweise oder vollständig fluorierten Alkyl-, Aminoalkyl-, Alkyoxyalkyl-, Hydroxyalkyl-, Phosphinoalkyl- oder Arylrest mit einem bis 20 Kohlenstoffatomen bedeuten,
ausgenommen Triphenylphosphino-Kupfer(I)formiat und 1,1,1-Tris(diphenylphosphinomethyl)ethan-Kupfer(I)formiat.

10. Verfahren nach Anspruch 9, **dadurch gekennzeichnet, dass** man den Kupfer(I)formiatkomplex aus der Gasphase abscheidet und gleichzeitig zersetzt.

11. Verfahren nach Anspruch 9, **dadurch gekennzeichnet, dass** man das Substrat mit einer Lösung des Kupfer(I)formiatkomplexes besprüht und diesen gleichzeitig oder anschließend zersetzt.

12. Verfahren nach Anspruch 9, **dadurch gekennzeichnet, dass** man eine Lösung des Kupfer(I)formiatkomplexes auf ein sich drehendes Substrat aufbringt und den Kupfer(I)formiatkomplex gleichzeitig oder anschließend zersetzt.

13. Verwendung eines Kupfer(I)formiatkomplexes der allgemeinen Formel LₙCu(HCOO) · x HCOOH als Einsatzstoff zur Abscheidung von metallischem Kupfer mittels CVD, wobei x eine Zahl von 0 bis 10 ist, n 1, 2, 3 oder 4 beträgt und die n Liganden L unabhängig voneinander jeweils einen der folgenden Liganden bedeuten:
- ein Phosphan der Formel R¹R²R³P,
- ein Phosphit der Formel (R¹O)(R²O)(R³O)P,
- ein Isocyanid der Formel R¹-NC,
- ein Alken der allgemeinen Formel R¹R²C=CR³R⁴, oder
- ein Alkin der allgemeinen Formel R¹C≡CR²,
wobei R¹, R², R³ und R⁴ unabhängig voneinander Wasserstoff, einen linearen oder verzweigten, wahlweise teilweise oder vollständig fluorierten Alkyl-, Aminoalkyl-, Alkyoxyalkyl-, Hydroxyalkyl-, Phosphinoalkyl- oder Arylrest mit einem bis 20 Kohlenstoffatomen bedeuten,
ausgenommen Triphenylphosphino-Kupfer(I)formiat und 1,1,1-Tris(diphenylphosphinomethyl)ethan-Kupfer(I)formiat.

## Claims

1. A copper(I) formate complex of the formula LₙCu(HCOO) · x HCOOH, where x is from 0 to 10, n is 1, 2, 3 or 4 and the n ligands L, independently of one another, are each one of the following ligands:
- a phosphane of the formula R¹R²R³P,
where R¹, R² and R³, independently of one another, are hydrogen, a linear or branched, optionally partly or completely fluorinated alkyl, aminoalkyl, alkoxyalkyl, hydroxyalkyl, phosphinoalkyl radical of one to 20 carbon atoms, or;
- a phosphite of the formula (R¹O) (R²O) (R³O) P,
- an isocyanide of the formula R¹-NC,
- an alkene of the formula R¹R²C=CR³R⁴, or
- an alkyne of the formula R¹C≡CR²,
where R¹, R², R³ and R⁴, independently of one another, are hydrogen, a linear or branched, optionally partly or completely fluorinated alkyl, aminoalkyl, alkoxyalkyl, hydroxyalkyl, phosphinoalkyl or aryl radical of one to 20 carbon atoms.

2. The copper(I) formate complex according to claim 1, wherein n is 2 or 3.

3. The copper(I) formate complex according to claim 1 or 2, wherein L is selected from the group consisting of trimethylphosphine, triethylphosphine, triisopropylphosphine, tri-n-butylphosphine, triisobutylphosphine, tricyclopentylphosphine, trimethoxyphosphine, triethoxyphosphine, triisopropoxyphosphine, tri(2,2,2-trifluoroethoxy)phosphine, isopropyl isocyanide, n-butyl isocyanide, tert-butyl isocyanide and cyclohexyl isocyanide.

4. The copper(I) formate complex according to claim 3, wherein L is tri-n-butylphosphine.

5. The copper(I) formate complex according to claim 4, wherein x is 1.

6. A process for the preparation of a copper(I) formate complex defined in any of claims 1 to 5 by reacting copper(I) formate with ligand L and optionally formic acid.

7. The process according to claim 6, wherein the copper(I) formate is obtained in a first step from copper(II) formate, metallic copper and formic acid and is not isolated before addition of the ligand L.

8. A process for the preparation of a copper(I) formate complex defined in any of claims 1 to 5 by reacting a copper(I) halide complex of the formula LₙCu(I)X, where X is a halide and L and n have the meanings defined in claim 1, with formic acid and then with a base.

9. A process for depositing metallic copper on a substrate by application of a copper(I) formate complex of the formula LₙCu(HCOO) · x HCOOH to the substrate and thermal decomposition of the copper(I) formate complex at a temperature of at least 80°C, where x is from 0 to 10, n is 1, 2, 3 or 4 and the n ligands L, independently of one another, are each one of the following ligands:
- a phosphane of the formula R¹R²R³P,
- a phosphite of the formula (R¹O) (R²O) (R³O) P,
- an isocyanide of the formula R¹-NC,
- an alkene of the formula R¹R²C=CR³R⁴, or
- an alkyne of the formula R¹C≡CR²,
where R¹, R², R³ and R⁴, independently of one another, are hydrogen, a linear or branched, optionally partly or completely fluorinated alkyl, aminoalkyl, alkoxyalkyl, hydroxyalkyl, phosphinoalkyl or aryl radical of one to 20 carbon atoms,
with the exception of triphenylphosphinocopper(I) formate and 1,1,1-tris(diphenylphosphinomethyl)ethanecopper(I) formate.

10. The process according to claim 9, wherein the copper(I) formate complex is deposited from the gas phase and simultaneously decomposed.

11. The process according to claim 9, wherein the substrate is sprayed with a solution of the copper(I) formate complex and the latter is simultaneously or subsequently decomposed.

12. The process according to claim 9, wherein a solution of the copper(I) formate complex is applied to a rotating substrate and the copper(I) formate complex is simultaneously or subsequently decomposed.

13. The use of a copper (I) formate complex of the formula LₙCu(HCOO) · x HCOOH as starting material for the deposition of metallic copper by means of CVD, where x is from 0 to 10, n is 1, 2, 3 or 4 and the n ligands L, independently of one another, are each one of the following ligands:
- a phosphane of the formula R¹R²R³P,
- a phosphite of the formula (R¹O) (R²O) (R³O) P,
- an isocyanide of the formula R¹-NC,
- an alkene of the formula R¹R²C=CR³R⁴, or
- an alkyne of the formula R¹C≡CR²,
where R¹, R², R³ and R⁴, independently of one another, are hydrogen, a linear or branched, optionally partly or completely fluorinated alkyl, aminoalkyl, alkoxyalkyl, hydroxyalkyl, phosphinoalkyl or aryl radical of one to 20 carbon atoms,
with the exception of triphenylphosphinocopper(I) formate and 1,1,1-tris(diphenylphosphinomethyl)ethanecopper(I) formate.

## Revendications

1. Complexes de formiate de cuivre (I) de formule générale LₙCu(HCOO) •x HCOOH, où x est un nombre de 0 à 10, n vaut 1, 2, 3 ou 4 et les n ligands L signifient indépendamment les uns des autres à chaque fois un des ligands suivants :
- un phosphane de formule R¹R²R³P,
où R¹, R² et R³ signifient, indépendamment les uns des autres, hydrogène, un radical alkyle, aminoalkyle, alkyloxyalkyle, hydroxyalkyle, phosphinoalkyle, comprenant jusqu'à 20 atomes de carbone, linéaire ou ramifié, éventuellement partiellement ou complètement fluoré ;
ou
- un phosphite de formule (R¹O) (R²O) (R³O) P,
- un isocyanure de formule R¹-NC,
- un alcène de formule générale R¹R²C=CR³R⁴, ou
- un alcyne de formule générale R¹C≡CR²,
où R¹, R², R³ et R⁴ signifient, indépendamment les uns des autres, hydrogène, un radical alkyle, aminoalkyle, alkyloxyalkyle, hydroxyalkyle, phosphinoalkyle ou aryle, comprenant jusqu'à 20 atomes de carbone, linéaire ou ramifié, éventuellement partiellement ou complètement fluoré.

2. Complexes de formiate de cuivre (I) selon la revendication 1, **caractérisés en ce que** n vaut 2 ou 3.

3. Complexes de formiate de cuivre (I) selon la revendication 1 ou 2, **caractérisés en ce que** L est choisi dans le groupe formé par la triméthylphosphine, la triéthylphosphine, la triisopropylphosphine, la tri-n-butylphosphine, la triisobutylphosphine, la tricyclopentylphosphine, la triméthoxyphosphine, la triéthoxyphosphine, la triisopropoxyphosphine, la tri(2,2,2-trifluoréthoxy)phosphine, l'isocyanure d'isopropyle, l'isocyanure de n-butyle, l'isocyanure de tert-butyle et l'isocyanure de cyclohexyle.

4. Complexes de formiate de cuivre (I) selon la revendication 3, **caractérisés en ce que** L est la tri-n-butylphosphine.

5. Complexes de formiate de cuivre (I) selon la revendication 4, **caractérisés en ce que** x vaut 1.

6. Procédé pour la préparation des complexes de formiate de cuivre (I) définis dans les revendications 1 à 5 par transformation de formiate de cuivre (I) avec le ligand L et éventuellement avec de l'acide formique.

7. Procédé selon la revendication 6, **caractérisé en ce qu'**on obtient le formiate de cuivre (I) dans une première étape à partir de formiate de cuivre (II), de cuivre métallique et d'acide formique et qu'on ne l'isole pas avant l'addition du ligand L.

8. Procédé pour la préparation des complexes de formiate de cuivre (I) définis dans les revendications 1 à 5 par transformation d'un complexe d'halogénure de cuivre (I) de formule LₙCu(I)X, où X représente un halogénure et L et n ont les significations définies dans la revendication 1, avec de l'acide formique et ensuite avec une base.

9. Procédé pour le dépôt de cuivre métallique sur un substrat par application d'un complexe de formiate de cuivre (I) de formule générale LₙCu(HCOO) •x HCOOH sur le substrat et décomposition thermique du complexe de formiate de cuivre (I) à une température d'au moins 80°C, où x est un nombre de 0 à 10, n vaut 1, 2, 3 ou 4 et les n ligands L signifient, indépendamment les uns des autres, un des ligands suivants :
- un phosphane de formule R¹R²R³P,
- un phosphite de formule (R¹O) (R²O) (R³O) P,
- un isocyanure de formule R¹-NC,
- un alcène de formule générale R¹R²C=CR³R⁴, ou
- un alcyne de formule générale R¹C≡CR²,
où R¹, R², R³ et R⁴ signifient, indépendamment les uns des autres, hydrogène, un radical alkyle, aminoalkyle, alkyloxyalkyle, hydroxyalkyle, phosphinoalkyle ou aryle, comprenant jusqu'à 20 atomes de carbone, linéaire ou ramifié, éventuellement partiellement ou complètement fluoré,
à l'exception du triphénylphosphino-formiate de cuivre (I) et du 1,1,1-tris(diphénylphosphinométhyl)éthaneformiate de cuivre (I).

10. Procédé selon la revendication 9, **caractérisé en ce qu'**on dépose le complexe de formiate de cuivre (I) à partir de la phase gazeuse et on le décompose simultanément.

11. Procédé selon la revendication 9, **caractérisé en ce qu'**on asperge le substrat par une solution du complexe de formiate de cuivre (I) et on le décompose simultanément ou consécutivement.

12. Procédé selon la revendication 9, **caractérisé en ce qu'**on applique une solution du complexe de formiate de cuivre (I) sur un substrat en rotation et on décompose le complexe de formiate de cuivre (I) simultanément ou consécutivement.

13. Utilisation d'un complexe de formiate de cuivre (I) de formule générale LₙCu(HCOO) •x HCOOH comme matière première pour le dépôt de cuivre métallique par CVD (dépôt chimique en phase vapeur), où x est un nombre de 0 à 10, n vaut 1, 2, 3 ou 4 et les n ligands L signifient indépendamment les uns des autres à chaque fois un des ligands suivants :
- un phosphane de formule R¹R²R³P,
- un phosphite de formule (R¹O) (R²O) (R³O) P,
- un isocyanure de formule R¹-NC,
- un alcène de formule générale R¹R²C=CR³R⁴, ou
- un alcyne de formule générale R¹C≡CR²,
où R¹, R², R³ et R⁴ signifient, indépendamment les uns des autres, hydrogène, un radical alkyle, aminoalkyle, alkyloxyalkyle, hydroxyalkyle, phosphinoalkyle ou aryle, comprenant jusqu'à 20 atomes de carbone, linéaire ou ramifié, éventuellement partiellement ou complètement fluoré,
à l'exception du triphénylphosphino-formiate de cuivre (I) et du 1,1,1-tris(diphénylphosphinométhyl)éthaneformiate de cuivre (I).
